# EUROPÄISCHE PATENTSCHRIFT

(11) **EP 3 874 282 B1**
(45) Veröffentlichungstag und Bekanntmachung des Hinweises auf die Patenterteilung: **05.06.2024**
(21) Anmeldenummer: 19780231.7
(22) Anmeldetag: 30.09.2019
(51) Int. Cl.: G01R 19/165

(54) **ÜBERSPANNUNGSSCHUTZSCHALTUNG FÜR EIN STEUERGERÄT FÜR EIN FAHRZEUG, STEUERGERÄT FÜR EIN FAHRZEUG UND VERFAHREN ZUM TESTEN EINER ÜBERSPANNUNGSSCHUTZSCHALTUNG FÜR EIN STEUERGERÄT FÜR EIN FAHRZEUG**
OVERVOLTAGE PROTECTION CIRCUIT FOR A CONTROL UNIT FOR A VEHICLE, CONTROL UNIT FOR A VEHICLE AND METHOD FOR TESTING AN OVERVOLTAGE PROTECTION CIRCUIT FOR A CONTROL UNIT FOR A VEHICLE
CIRCUIT LIMITEUR DE TENSION POUR UN APPAREIL DE COMMANDE POUR UN VÉHICULE, APPAREIL DE COMMANDE POUR UN VÉHICULE ET PROCÉDÉ DE TEST D'UN CIRCUIT LIMITEUR DE TENSION POUR UN APPAREIL DE COMMANDE POUR UN VÉHICULE

(30) Priorität: 29.10.2018 DE 102018126913
(43) Veröffentlichungstag der Anmeldung: 08.09.2021
(73) Patentinhaber: KNORR-BREMSE Systeme für Nutzfahrzeuge GmbH, 80809 München (DE)
(72) Erfinder: FEUCHT, Thomas, 71299 Wimsheim (DE); HERRMANN, Günter, 70569 Stuttgart (DE); SCHOLL, Frank, 74379 Ingersheim (DE)
(86) Internationale Anmeldenummer: PCT/EP2019/076436
(87) Internationale Veröffentlichungsnummer: WO 2020/088864

(56) Entgegenhaltungen:
- EP-A2- 2 568 558
- DE-A1-102011 089 556
- DE-A1-102013 108 302
- DE-T5-112015 002 196
- JP-B2- 3 860 089
- US-A1- 2010 194 352

## Beschreibung

Die vorliegende Erfindung bezieht sich auf eine Überspannungsschutzschaltung für ein Steuergerät für ein Fahrzeug, auf ein Steuergerät für ein Fahrzeug und auf ein Verfahren zum Testen einer Überspannungsschutzschaltung für ein Steuergerät für ein Fahrzeug.

Für Steuergeräte und dergleichen können Überspannungsschutzschaltungen zum Beispiel in Gestalt von Z-Dioden zum Einsatz kommen, welche üblicherweise während einer Lebensdauer der Steuergeräte nicht auf korrekte Funktion geprüft werden können. Die DE 11 2015 002 196 T5 bezieht sich auf eine Spannungsdetektionseinrichtung, die einen ersten Widerstand zum Teilen der Spannung einer Detektionseinheit in einen ersten geteilten Spannungswert; und eine Testmustereinfügungsschaltungseinheit umfasst, die einen zweiten Widerstand zum Teilen des ersten geteilten Spannungswerts in einen zweiten geteilten Spannungswert und eine Schaltvorrichtung enthält, wobei die Testmustereinfügungsschaltungseinheit mit einem Äquipotentialverbindungspunkt mit dem ersten geteilten Spannungswert verbunden ist. Die DE 10 2013 108 302 A1 offenbart für einen Verstärker eine Fehlerschutzsteuerschaltung, die durch den Signalpol mit einer Vorbeeinflussung beaufschlagt ist, und eine Fehlerschutzschaltung, die einen ersten Transistor und einen zweiten Transistor beinhaltet. Die Quellen und Körper des ersten und zweiten Transistors können miteinander verbunden sein, der Drain des ersten Transistors kann mit dem Ausgang des Verstärkers verbunden sein und der Drain des zweiten Transistors kann mit einem Signalpol verbunden sein.

Vor diesem Hintergrund ist es die Aufgabe der vorliegenden Erfindung, eine verbesserte Überspannungsschutzschaltung für ein Steuergerät für ein Fahrzeug, ein verbessertes Steuergerät für ein Fahrzeug und ein verbessertes Verfahren zum Testen einer Überspannungsschutzschaltung für ein Steuergerät für ein Fahrzeug zu schaffen.

Diese Aufgabe wird durch eine Überspannungsschutzschaltung für ein Steuergerät für ein Fahrzeug und durch ein Verfahren zum Testen einer Überspannungsschutzschaltung für ein Steuergerät für ein Fahrzeug gemäß den Hauptansprüchen gelöst.

Gemäß Ausführungsformen kann insbesondere eine Überwachbarkeit eines Überspannungsschutzes für ein Steuergerät, insbesondere für einen sicherheitsrelevanten Spannungsversorgungsbaustein, bereitgestellt werden. Somit kann eine Überspannungsschutzschaltung beispielsweise auch zur Erhöhung von Sicherheitsanforderungen herangezogen werden. Für die Realisierung einer solchen Überspannungsschutzschaltung können gemäß Ausführungsformen insbesondere diskrete Bauelemente verwendet werden, sodass die Überspannungsschutzschaltung in weiten Spannungsbereichen gestellten Anforderungen angepasst werden kann.

Somit kann es ermöglicht werden, eine Überspannungsschutzschaltung in einem Steuergerät zu prüfen. Hierbei kann zum Testen der Überspannungsschutzschaltung insbesondere eine zyklische Ansteuerung der Überspannungsschutzschaltung mit zwei unterschiedlich hohen Eingangspegeln erfolgen.

Vorteilhafterweise kann gemäß Ausführungsformen insbesondere ein kostengünstiger, testbarer Überspannungsschutz für eine steuergeräteinterne Spannungsversorgung bereitgestellt werden. Hierbei kann beispielsweise auch ermöglicht werden, eine Spannungsversorgung erst ab einer vordefinierten Spannung einzuschalten. Anders ausgedrückt kann somit insbesondere ein Test einer Überspannungsschutzschaltung in einem Normalspannungsbereich während einer gesamten Lebensdauer der Schaltung ermöglicht werden. Zudem kann die Überspannungsschutzschaltung beispielsweise ohne Spezialbauelemente bzw. lediglich unter Verwendung von Standardbauelementen aufgebaut sein. Ferner kann insbesondere eine Einstellung einer beliebigen Begrenzerspannung sowohl in einem Normalbetrieb als auch in einem Testbetrieb der Überspannungsschutzschaltung ermöglicht werden. Ein solcher Testbetrieb bzw. eine Durchführung eines Tests kann unter Verwendung lediglich eines zusätzlichen Anschlusses zur Testansteuerung erfolgen, sodass Ressourcen insbesondere hinsichtlich Hardware eingespart werden können.

Eine Überspannungsschutzschaltung für ein Steuergerät für ein Fahrzeug weist folgende Merkmale auf:
einen Eingangsanschluss zum Anlegen einer elektrischen Eingangsspannung, einen Testanschluss zum Anlegen einer elektrischen Testspannung und einen Ausgangsanschluss zum Bereitstellen einer elektrischen Ausgangsspannung zum Versorgen des Steuergeräts;
eine Referenzeinrichtung, die ausgebildet ist, um unter Verwendung der Eingangsspannung eine Referenzspannung bereitzustellen;
eine Teilungseinrichtung, die ausgebildet ist, um unter Verwendung der Ausgangsspannung eine Teilspannung bereitzustellen;
eine Steuereinrichtung, die ausgebildet ist, um unter Verwendung der Referenzspannung und der Teilspannung ein Regulierungssignal bereitzustellen;
eine Regulierungseinrichtung, die zwischen den Eingangsanschluss und den Ausgangsanschluss geschaltet ist, wobei die Regulierungseinrichtung ausgebildet ist, um die Ausgangsspannung unter Verwendung der Eingangsspannung und des Regulierungssignals bereitzustellen; und
eine Modifizierungseinrichtung, die ausgebildet ist, um einen Wert der Teilspannung unter Verwendung der Testspannung zu modifizieren.

Die Überspannungsschutzschaltung kann als ein Teil des Steuergerätes ausgeführt sein oder kann in das Steuergerät integrierbar sein. Das Steuergerät kann in dem Fahrzeug angeordnet sein oder werden. Bei dem Fahrzeug kann es sich um ein Kraftfahrzeug handeln, insbesondere ein Landfahrzeug, Luftfahrzeug oder Wasserfahrzeug, beispielsweise einen Personenkraftwagen, Lastkraftwagen oder ein anderes Nutzfahrzeug. Im Zusammenhang mit der Überspannungsschutzschaltung kann verbunden bedeuten, dass eine elektrische Verbindung direkt oder über zumindest ein Bauteil hergestellt ist, beispielsweise einen elektrischen Widerstand oder dergleichen. Das Regulierungssignal kann eine elektrische Spannung und zusätzlich oder alternativ einen elektrischen Strom repräsentieren. Die einzelnen Einrichtungen können unter Verwendung diskreter Bauteile, beispielsweise unter Verwendung von Widerständen und Transistoren realisiert sein.

Gemäß einer Ausführungsform kann die Regulierungseinrichtung einen Transistor mit einem ersten Anschluss, einem zweiten Anschluss und einem Steueranschluss zum Empfangen des Regulierungssignals aufweisen. Hierbei kann der erste Anschluss des Transistors mit dem Eingangsanschluss verbunden sein. Der zweite Anschluss des Transistors kann mit dem Ausgangsanschluss verbunden sein. Der Steueranschluss des Transistors kann mit der Steuereinrichtung verbunden sein. Bei dem Transistor kann es sich um einen pnp-Transistor handeln. Es kann jedoch als der Transistor auch ein anderer geeigneter Typ von Transistor verwendet werden. Eine solche Ausführungsform bietet den Vorteil, dass eine sichere, vor Überspannung geschützte Ausgangsspannung auf einfache Weise bereitgestellt werden kann.

Ferner kann die Steuereinrichtung einen Operationsverstärker mit einem invertierenden Eingang, einem nicht-invertierenden Eingang und einem Ausgang aufweisen. Hierbei kann der invertierende Eingang des Operationsverstärkers zum Empfangen der Referenzspannung mit der Referenzeinrichtung verbunden sein. Der nicht-invertierende Eingang des Operationsverstärkers kann zum Empfangen der Teilspannung mit der Teilungseinrichtung und zum Modifizieren der Teilspannung mit der Modifizierungseinrichtung verbunden sein. Der Ausgang des Operationsverstärkers kann zum Bereitstellen des Regulierungssignals mit der Regulierungseinrichtung verbunden sein. Genauer gesagt kann der Ausgang des Operationsverstärkers mit dem Steueranschluss des Transistors der Regulierungseinrichtung verbunden sein. Eine solche Ausführungsform bietet den Vorteil, dass ein zuverlässiger Schutz vor Überspannung bereitgestellt werden kann. Hierbei kann insbesondere ein Regulierungssignal bereitgestellt werden, das für eine sichere Regulierung der Ausgangsspannung geeignet ist.

Auch kann die Modifizierungseinrichtung einen Schalter und einen elektrischen Modifizierungswiderstand aufweisen. Hierbei können der Schalter und der Modifizierungswiderstand miteinander in Reihe zwischen Bezugspotenzial und die Steuereinrichtung geschaltet sein. Dabei kann ein Steueranschluss des Schalters mit dem Testanschluss verbunden sein. Genauer gesagt können der Schalter und der Modifizierungswiderstand miteinander in Reihe zwischen Bezugspotenzial und den nicht-invertierenden Eingang des Operationsverstärkers der Steuereinrichtung geschaltet sein. Der Schalter kann als ein npn-Transistor oder als eine andere geeignete Art eines Transistors ausgeführt sein. Eine solche Ausführungsform bietet den Vorteil, dass Testbarkeit der Überspannungsschutzschaltung auf einfache und sichere Weise realisiert werden kann.

Zudem kann die Teilungseinrichtung einen ersten elektrischen Teilungswiderstand und einen zweiten elektrischen Teilungswiderstand aufweisen. Hierbei kann ein erster Anschluss des ersten Teilungswiderstands mit dem Ausgangsanschluss verbunden sein. Ein zweiter Anschluss des ersten Teilungswiderstands kann mit einem ersten Anschluss des zweiten Teilungswiderstands verbunden sein. Ein zweiter Anschluss des zweiten Teilungswiderstands kann mit Bezugspotenzial verbunden sein. Der zweite Anschluss des ersten Teilungswiderstands kann zum Bereitstellen der Teilspannung mit der Steuereinrichtung verbunden sein. Widerstandswerte der Teilungswiderstände sind hierbei je nach Anwendungsszenario vordefinierbar. Eine solche Ausführungsform bietet den Vorteil, dass die Teilspannung zuverlässig und genau bereitgestellt werden kann.

Ferner kann die Referenzeinrichtung einen Referenzanschluss zum Anlegen der Referenzspannung aufweisen. Alternativ kann die Referenzeinrichtung einen Referenzwiderstand, eine erste Diode und eine zweite Diode aufweisen. Hierbei können der Referenzwiderstand, die erste Diode und die zweite Diode miteinander in Reihe zwischen einen Steueranschluss zum Anlegen einer elektrischen Steuerspannung und Bezugspotenzial oder zwischen den Eingangsanschluss und Bezugspotenzial geschaltet sein. Ein Referenzknoten zwischen der ersten Diode und der zweiten Diode kann mit der Steuereinrichtung verbunden sein. Die erste Diode kann als eine Zener-Diode oder eine andere geeignete Art von Diode ausgeführt sein. Die zweite Diode kann als eine Zener-Diode oder eine andere geeignete Art von Diode ausgeführt sein. Eine solche Ausführungsform bietet den Vorteil, dass eine Referenzspannung unaufwendig bereitgestellt werden kann. Auch kann insbesondere mittels der ersten Diode eine Einschalthysterese der Überspannungsschutzschaltung eingestellt werden. Sind der Referenzwiderstand, die erste Diode und die zweite Diode miteinander in Reihe zwischen den Eingangsanschluss und Bezugspotenzial geschaltet, kann eine Anzahl von Anschlüssen hinsichtlich des Steuergeräts reduziert werden.

Insbesondere kann hinsichtlich der Steuereinrichtung der Operationsverstärker zwei npn-Verstärkertransistoren, einen pnp-Verstärkertransistor, zwei Verstärkerkondensatoren und drei elektrische Verstärkerwiderstände aufweisen. Hierbei kann der invertierende Eingang des Operationsverstärkers als ein Steueranschluss eines ersten der npn-Verstärkertransistoren ausgeführt sein. Der nicht-invertierende Eingang des Operationsverstärkers kann als ein Steueranschluss eines zweiten der npn-Verstärkertransistoren ausgeführt sein. Ein erster Anschluss des ersten der npn-Verstärkertransistoren und ein erster Anschluss des zweiten der npn-Verstärkertransistoren können über einen ersten der Verstärkerwiderstände mit Bezugspotenzial verbunden sein. Ein zweiter Anschluss des ersten der npn-Verstärkertransistoren kann mit einem zweiten Anschluss des pnp-Verstärkertransistors und zum Bereitstellen des Regulierungssignals mit der Regulierungseinrichtung verbunden sein. Ein zweiter Anschluss des zweiten der npn-Verstärkertransistoren kann mit dem Ausgangsanschluss verbunden sein. Ein erster Anschluss des pnp-Verstärkertransistors kann mit dem Eingangsanschluss verbunden sein. Ein Steueranschluss des pnp-Verstärkertransistors kann über einen zweiten der Verstärkerwiderstände mit der Regulierungseinrichtung verbunden sein. Ein erster Anschluss eines ersten der Verstärkerkondensatoren kann mit dem Eingangsanschluss verbunden sein. Ein zweiter Anschluss des ersten der Verstärkerkondensatoren kann zwischen den Steueranschluss des pnp-Verstärkertransistors und den zweiten der Verstärkerwiderstände geschaltet sein. Ein erster Anschluss eines dritten der Verstärkerwiderstände kann mit dem Steueranschluss des ersten der npn-Verstärkertransistoren verbunden sein. Ein zweiter Anschluss des dritten der Verstärkerwiderstände kann mit dem Ausgangsanschluss verbunden sein. Ein erster Anschluss eines zweiten der Verstärkerkondensatoren kann mit dem Steueranschluss des ersten der npn-Verstärkertransistoren verbunden sein. Ein zweiter Anschluss des zweiten der Verstärkerkondensatoren kann mit Bezugspotenzial verbunden sein. Die Verstärkertransistoren können auch andere geeignete Arten von Transistoren sein. Eine solche Ausführungsform bietet den Vorteil, dass auf zuverlässige Weise ein Regulierungssignal bereitgestellt werden kann, das einen sicheren Schutz vor Überspannung ermöglicht.

Gemäß einer Ausführungsform kann die Überspannungsschutzschaltung eine Einstelleinrichtung zum Einstellen des Regulierungssignals unter Verwendung der Eingangsspannung aufweisen. Hierbei kann die Einstelleinrichtung eine Reihenschaltung aus einem Schalter und einem ersten elektrischen Einstellwiderstand aufweisen, die zwischen die Steuereinrichtung und Bezugspotenzial geschaltet sein kann. Dabei kann der Schalter abhängig von der Eingangsspannung schaltbar sein. Genauer gesagt kann die Reihenschaltung zwischen den ersten Anschluss des zweiten der npn-Verstärkertransistoren des Operationsverstärkers der Steuereinrichtung und Bezugspotenzial geschaltet sein. Eine solche Ausführungsform bietet den Vorteil, dass ein Basisstrom des Transistors der Regulierungseinrichtung in Abhängigkeit von der Eingangsspannung gesteuert werden kann.

Auch kann bei der Einstelleinrichtung der Schalter als ein erster npn-Einstelltransistor ausgeführt sein. Hierbei kann die Einstelleinrichtung ferner einen zweiten npn-Einstelltransistor, einen zweiten Einstellwiderstand, einen dritten Einstellwiderstand, einen vierten Einstellwiderstand und einen fünften Einstellwiderstand aufweisen. Ein erster Anschluss des ersten npn-Einstelltransistors kann mit einem ersten Anschluss des ersten Einstellwiderstands verbunden sein. Ein zweiter Anschluss des ersten Einstellwiderstands kann mit Bezugspotenzial verbunden sein. Ein zweiter Anschluss des ersten npn-Einstelltransistors kann mit der Steuereinrichtung verbunden sein. Ein Steueranschluss des ersten npn-Einstelltransistors kann mit einem zweiten Anschluss des zweiten npn-Einstelltransistors verbunden sein. Der erste Anschluss des zweiten npn-Einstelltransistors kann mit Bezugspotenzial verbunden sein. Der zweite Einstellwiderstand und der dritte Einstellwiderstand können miteinander in Reihe zwischen den Eingangsanschluss und Bezugspotenzial geschaltet sein. Ein Steueranschluss des zweiten npn-Einstelltransistors kann mit einem Einstellknoten zwischen dem zweiten Einstellwiderstand und dem dritten Einstellwiderstand verbunden sein. Ein erster Anschluss des vierten Einstellwiderstands kann mit dem Einstellknoten verbunden sein. Ein zweiter Anschluss des vierten Einstellwiderstands kann mit dem zweiten Anschluss des zweiten npn-Einstelltransistors verbunden sein. Ein erster Anschluss des fünften Einstellwiderstands kann mit dem zweiten Anschluss des zweiten npn-Einstelltransistors verbunden sein. Ein zweiter Anschluss des fünften Einstellwiderstands kann mit dem Eingangsanschluss verbunden sein. Genauer gesagt kann der zweite Anschluss des ersten npn-Einstelltransistors mit dem ersten Anschluss des zweiten der npn-Verstärkertransistoren des Operationsverstärkers der Steuereinrichtung verbunden sein. Die Einstelltransistoren können alternativ auch andere geeignete Arten von Transistoren sein. Eine solche Ausführungsform bietet den Vorteil, dass mit der Ausgangsspannung auch ein Schaltregler des Steuergeräts in geeigneter Weise versorgt werden kann.

Ferner kann die Überspannungsschutzschaltung einen elektrischen Begrenzungswiderstand aufweisen. Hierbei kann ein erster Anschluss des Begrenzungswiderstands mit dem Eingangsanschluss verbunden sein. Ein zweiter Anschluss des Begrenzungswiderstands kann mit der Regulierungseinrichtung verbunden sein. Der zweite Anschluss des Begrenzungswiderstands kann mit dem ersten Anschluss des Transistors der Regulierungseinrichtung verbunden sein. Ein Widerstandswert des Begrenzungswiderstands kann abhängig von einer vorgesehenen Strombegrenzung eines Ausgangsstroms vordefinierbar sein. Somit kann eine vordefinierbare Strombegrenzung auf einfache Weise realisiert werden.

Ein Steuergerät für ein Fahrzeug weist eine Ausführungsform der vorstehend genannten Überspannungsschutzschaltung und einen Spannungsversorgungsanschluss auf, wobei der Ausgangsanschluss der Überspannungsschutzschaltung mit dem Spannungsversorgungsanschluss des Steuergerätes verbunden ist.

Die Überspannungsschutzschaltung kann in Verbindung mit dem Steuergerät vorteilhaft eingesetzt oder verwendet werden, um einen Überspannungsschutz hinsichtlich einer Spannungsversorgung des Steuergerätes bereitzustellen.

Gemäß einer Ausführungsform kann das Steuergerät eine Testeinrichtung zum Testen einer Funktionalität der Überspannungsschutzschaltung umfassen. Dabei kann die Testeinrichtung ausgebildet sein, um einen ersten Wert oder ersten Werteverlauf der elektrischen Ausgangsspannung zu erfassen während an dem Testanschluss die einen ersten Spannungspegel aufweisende elektrischen Testspannung anliegt, und einen zweiten Wert oder zweiten Werteverlauf der elektrischen Ausgangsspannung zu erfassen, während an dem Testanschluss die einen zweiten Spannungspegel aufweisende elektrischen Testspannung anliegt. Unter Verwendung des ersten Werts oder ersten Werteverlaufs sowie des zweiten Werts oder zweiten Werteverlaufs ein kann die Testeinrichtung ein Testsignal bereitzustellen. Die Testeinrichtung kann beispielsweise verwendet werden, um die Funktionalität der Überspannungsschutzschaltung bei einer Inbetriebnahme des Steuergeräts oder während eines Funktionstests des Steuergeräts zu überprüfen.

Ein Verfahren zum Testen einer Überspannungsschutzschaltung für ein Steuergerät für ein Fahrzeug, wobei die Überspannungsschutzschaltung eine Ausführungsform der vorstehend genannten Überspannungsschutzschaltung ist, weist folgende Schritte auf:
Anlegen einer elektrischen Testspannung mit einem ersten Spannungspegel an den Testanschluss der Überspannungsschutzschaltung;
Erfassen einer ersten elektrischen Ausgangsspannung ansprechend auf die elektrische Testspannung mit dem ersten Spannungspegel;
Anlegen einer elektrischen Testspannung mit einem zweiten Spannungspegel an den Testanschluss der Überspannungsschutzschaltung, wobei der zweite Spannungspegel niedriger als der erste Spannungspegel ist;
Erfassen einer zweiten elektrischen Ausgangsspannung ansprechend auf die elektrische Testspannung mit dem zweiten Spannungspegel;
überprüfen, ob die erfasste erste Ausgangsspannung und die erfasste zweite Ausgangsspannung zumindest ein Testkriterium erfüllen, um ein Testergebnis zu erzeugen.

Das Verfahren zum Testen ist ausführbar, um eine Ausführungsform der vorstehend genannten Überspannungsschutzschaltung auf vorteilhafte Weise auf ihre Funktionsfähigkeit zu überprüfen.

Ausführungsbeispiele des hier vorgestellten Ansatzes werden in der nachfolgenden Beschreibung mit Bezug zu den Figuren näher erläutert. Es zeigen:
Fig. 1 eine schematische Darstellung eines Fahrzeugs mit einem Steuergerät gemäß einem Ausführungsbeispiel;
Fig. 2 ein Prinzipschaltbild der Überspannungsschutzschaltung aus Fig. 1;
Fig. 3 ein Schaltbild der Überspannungsschutzschaltung aus Fig. 1 bzw. Fig. 2;
Fig. 4 ein Schaltbild der Überspannungsschutzschaltung aus Fig. 3 mit einer Einstelleinrichtung; und
Fig. 5 ein Ablaufdiagramm eines Verfahrens zum Testen gemäß einem Ausführungsbeispiel.

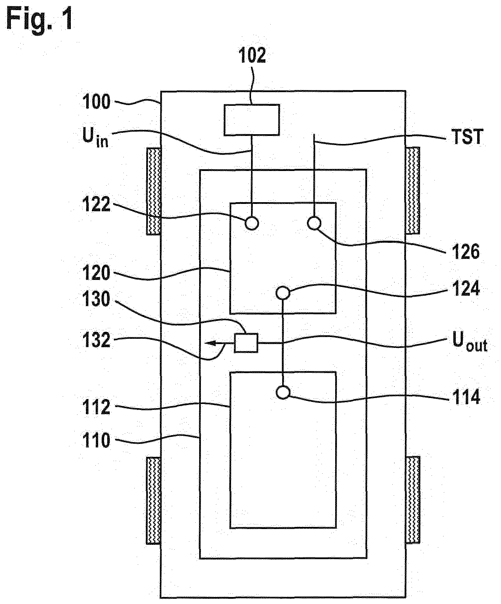

**Fig. 1** zeigt eine schematische Darstellung eines Fahrzeugs 100 mit einem Steuergerät 110 gemäß einem Ausführungsbeispiel. Bei dem Fahrzeug 100 handelt es sich um ein Kraftfahrzeug, beispielsweise einen Personenkraftwagen, einen Lastkraftwagen oder ein anderes Nutzfahrzeug. Das Steuergerät 110 ist in dem Fahrzeug 100 angeordnet. Somit weist das Fahrzeug 100 das Steuergerät 110 auf. Das Steuergerät 110 weist einen Eingang zum Anlegen einer elektrischen Eingangsspannung Uᵢₙ auf. Beispielsweise wird die Eingangsspannung Uᵢₙ von einer Batterie 102 des Fahrzeugs 100 bereitgestellt.

Das Steuergerät 110 weist eine Steuergeräteeinrichtung 112 aus, die ausgebildet ist, um eine Steuerfunktion des Steuergeräts 110 auszuführen. Die Steuerfunktion betrifft beispielsweise die Ansteuerung zumindest eines Aktuators eines Fahrzeugsystems des Fahrzeugs, beispielsweise eines Bremssystems.

Zum Versorgen der Steuergeräteeinrichtung 112 mit elektrischer Energie weist die Steuergeräteeinrichtung 112 einen Spannungsversorgungsanschluss 114 auf. Die Steuergeräteeinrichtung 112 ist über den Spannungsversorgungsanschluss 114 mit elektrischer Spannung versorgbar.

Das Steuergerät 110 weist eine Überspannungsschutzschaltung 120 auf, die zwischen den Spannungsversorgungsanschluss 114 der Steuergeräteeinrichtung 112 und dem Eingang des Steuergeräts 110 zum Anlegen der elektrischen Eingangsspannung Uᵢₙ geschaltet ist. Die Überspannungsschutzschaltung 120 ist ausgebildet, um einen Schutz vor elektrischer Überspannung für das Steuergerät 110 bzw. insbesondere für die Steuergeräteeinrichtung 112 des Steuergerätes 110 zu bewirken.

Von der Überspannungsschutzschaltung 120 sind in der Darstellung von Fig. 1 ein Eingangsanschluss 122 zum Anlegen der elektrischen Eingangsspannung Uᵢₙ an die Überspannungsschutzschaltung 120, ein Ausgangsanschluss 124 zum Bereitstellen einer elektrischen Ausgangsspannung Uₒᵤₜ zum Versorgen des Steuergeräts 110 bzw. der Steuergeräteeinrichtung 112 und ein Testanschluss 126 zum Anlegen einer elektrischen Testspannung TST an die Überspannungsschutzschaltung 120 gezeigt. Die Überspannungsschutzschaltung 120 und die Steuergeräteeinrichtung 112 sind miteinander verbunden. Hierbei ist der Ausgangsanschluss 124 der Überspannungsschutzschaltung 120 mit dem Spannungsversorgungsanschluss 114 verbunden. Anhand der nachfolgenden Figuren wird der Aufbau und die Funktion der Überspannungsschutzschaltung 120 gemäß unterschiedlicher Ausführungsbeispiele beschrieben.

Gemäß einem Ausführungsbeispiel ist eine Testeinrichtung 130 vorgesehen, die ausgebildet ist, um eine Funktionalität der Überspannungsschutzschaltung 120 zu testen. Die Testeinrichtung 130 ist gemäß einem Ausführungsbeispiel in das Steuergerät 110 integriert, kann aber auch Teil der Überspannungsschutzschaltung 120 sein oder als eine extern zu dem Steuergerät 110 angeordnete Schaltung sein. Die Testeinrichtung 130 ist ausgebildet, um einen ersten Wert oder ersten Werteverlauf der elektrischen Ausgangsspannung Uₒᵤₜ zu erfassen während an dem Testanschluss 126 die einen ersten Spannungspegel aufweisende elektrischen Testspannung TST anliegt. Ferner ist die Testeinrichtung 130 ausgebildet, um einen zweite Wert oder zweiten Werteverlauf der elektrischen Ausgangsspannung Uₒᵤₜ zu erfassen während an dem Testanschluss 126 die einen zweiten Spannungspegel aufweisende elektrischen Testspannung TST anliegt. Die Testeinrichtung 130 ist ausgebildet, um unter Verwendung des ersten Werts oder ersten Werteverlaufs sowie des zweiten Werts oder zweiten Werteverlaufs ein Testergebnis zu bestimmen und ein das Testergebnis anzeigendes Testsignal 132 bereitzustellen. Das Testsignal 132 zeigt beispielsweise eine korrekte Funktionalität der Überspannungsschutzschaltung 120 und zusätzlich oder alternativ eine fehlerhafte Funktionalität der Überspannungsschutzschaltung 120 an. Gemäß einem Ausführungsbeispiel ist die Testeinrichtung 130 ausgebildet, um die Testspannung TST zu empfangen. Alternativ ist die Testeinrichtung 130 ausgebildet, um die Testspannung TST bereitzustellen.

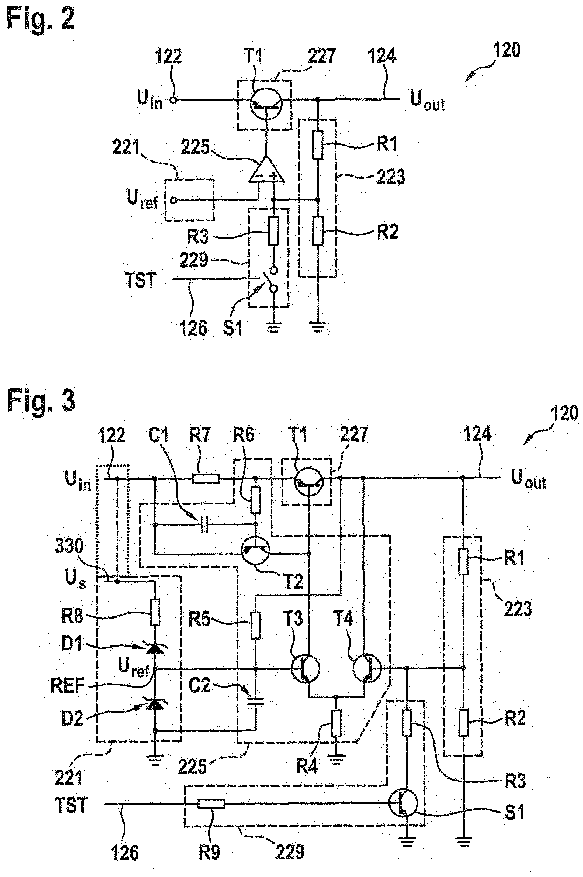

**Fig. 2** zeigt ein Prinzipschaltbild der Überspannungsschutzschaltung 120 aus Fig. 1 gemäß einem Ausführungsbeispiel. In dem Prinzipschaltbild von Fig. 2 sind von der Überspannungsschutzschaltung 120 der Eingangsanschluss 122 zum Anlegen der Eingangsspannung Uᵢₙ, der Ausgangsanschluss 124 zum Bereitstellen der Ausgangsspannung Uₒᵤₜ, der Testanschluss 126 zum Anlegen der Testspannung TST, sowie ferner eine Referenzeinrichtung 221, eine Referenzspannung U_{ref}, eine Teilungseinrichtung 223 mit einem ersten elektrischen Teilungswiderstand R1 und einem zweiten elektrischen Teilungswiderstand R2, eine Steuereinrichtung 225, eine Regulierungseinrichtung 227 mit einem Transistor T1 sowie eine Modifizierungseinrichtung 229 mit einem elektrischen Modifizierungswiderstand R3 und einem Schalter S1 gezeigt.

Die Referenzeinrichtung 221 ist ausgebildet, um die Referenzspannung U_{ref} bereitzustellen. Gemäß dem hier dargestellten Ausführungsbeispiel weist die Referenzeinrichtung 221 einen Referenzanschluss zum Anlegen der Referenzspannung U_{ref} auf. Gemäß einem Ausführungsbeispiel ist die Referenzeinrichtung 221 ausgebildet, um die Referenzspannung U_{ref} unter Verwendung der Eingangsspannung Uᵢₙ bereitzustellen.

Die Teilungseinrichtung 223 ist ausgebildet, um unter Verwendung der Ausgangsspannung Uₒᵤₜ eine Teilspannung bereitzustellen. Die Teilungseinrichtung 223 weist gemäß dem hier dargestellten Ausführungsbeispiel eine Reihenschaltung aus dem ersten elektrischen Teilungswiderstand R1 und dem zweiten elektrischen Teilungswiderstand R2 auf. Ein erster Anschluss des ersten Teilungswiderstands R1 ist mit dem Ausgangsanschluss 124 verbunden. Ein zweiter Anschluss des ersten Teilungswiderstands R1 ist mit einem ersten Anschluss des zweiten Teilungswiderstands R2 verbunden. Ein zweiter Anschluss des zweiten Teilungswiderstands R2 ist mit Bezugspotenzial verbunden. Der zweite Anschluss des ersten Teilungswiderstands R1 ist zum Bereitstellen der Teilspannung mit der Steuereinrichtung 225 verbunden.

Die Steuereinrichtung 225 ist ausgebildet, um unter Verwendung der Referenzspannung U_{ref} und der Teilspannung ein Regulierungssignal bereitzustellen.

Gemäß dem hier dargestellten Ausführungsbeispiel weist die Steuereinrichtung 225 einen Operationsverstärker auf. Der Operationsverstärker weist einen invertierenden Eingang (-), einen nicht-invertierenden Eingang (+) und einen Ausgang auf. Der invertierende Eingang des Operationsverstärkers ist zum Empfangen der Referenzspannung U_{ref} mit der Referenzeinrichtung 221 verbunden. Der nicht-invertierende Eingang des Operationsverstärkers ist zum Empfangen der Teilspannung mit der Teilungseinrichtung 223 und zum Modifizieren der Teilspannung mit der Modifizierungseinrichtung 229 verbunden. Der Ausgang des Operationsverstärkers ist zum Bereitstellen des Regulierungssignals mit der Regulierungseinrichtung 227 verbunden.

Die Regulierungseinrichtung 227 ist zwischen den Eingangsanschluss 122 und den Ausgangsanschluss 124 geschaltet. Die Regulierungseinrichtung 227 ist ausgebildet, um die Ausgangsspannung Uₒᵤₜ unter Verwendung der Eingangsspannung Uᵢₙ und des Regulierungssignals bereitzustellen bzw. zu regulieren. Gemäß dem hier dargestellten Ausführungsbeispiel weist die Regulierungseinrichtung 227 den Transistor T1 auf. Der Transistor T1 weist einen ersten Anschluss, einen zweiten Anschluss und einen Steueranschluss zum Empfangen des Regulierungssignals auf. Der erste Anschluss des Transistors T1 ist mit dem Eingangsanschluss 122 verbunden. Der zweite Anschluss des Transistors T1 ist mit dem Ausgangsanschluss 124 verbunden. Der Steueranschluss des Transistors T1 ist mit der Steuereinrichtung 225 verbunden. Bei dem Transistor T1 handelt es sich gemäß dem hier dargestellten Ausführungsbeispiel um einen pnp-Transistor.

Die Modifizierungseinrichtung 229 ist ausgebildet, um einen Wert der von der Teilungseinrichtung 223 bereitgestellten Teilspannung unter Verwendung der Testspannung TST zu modifizieren. Dazu ist die Modifizierungseinrichtung 229 mit dem Testeingang 126 verbunden oder weist die Modifizierungseinrichtung 229 den Testeingang 146 auf. Gemäß dem hier dargestellten Ausführungsbeispiel weist die Modifizierungseinrichtung 229 den Schalter S1 und den elektrischen Modifizierungswiderstand R3 auf. Der Schalter S1 und der Modifizierungswiderstand R3 sind miteinander in Reihe zwischen Bezugspotenzial und die Steuereinrichtung 225, genauer gesagt den nicht-invertierenden Eingang des Operationsverstärkers der Steuereinrichtung 225, geschaltet. Ein Steueranschluss des Schalters S1 ist mit dem Testanschluss 126 verbunden. Gemäß dem hier dargestellten Ausführungsbeispiel ist der Schalter S1 zwischen den Modifizierungswiderstand R3 und Bezugspotenzial geschaltet. Alternativ können die Positionen von Schalter S1 und Modifizierungswiderstand R3 vertauscht sein.

Die an dem Testeingang 126 anliegende Testspannung TST wird verwendet um einen Widerstandswert eines Gesamtwiderstands zu modifizieren, der zwischen dem nicht-invertierenden Eingang (+) des Operationsverstärkers 225 und dem Bezugspotenzial besteht. Dazu wird der Schalter S1 abhängig von einem Spannungspegel der Testspannung TST geschlossen und geöffnet.

Die Überspannungsschutzschaltung 120 kann als sogenannter testbarerer PRESTAB in sicherheitskritischen Systemen eingesetzt werden.

**Fig. 3** zeigt ein Schaltbild der Überspannungsschutzschaltung 120 aus Fig. 1 bzw. Fig. 2 gemäß einem Ausführungsbeispiel. Hierbei entspricht die Überspannungsschutzschaltung 120 der Überspannungsschutzschaltung aus Fig. 2 mit Ausnahme dessen, dass die Referenzeinrichtung 221 unterschiedlich ausgeführt und/oder detaillierter dargestellt ist, zusätzlich ein elektrischer Begrenzungswiderstand R7 vorgesehen ist, die Modifizierungseinrichtung 229 einen Schalter S1 in Gestalt eines Transistors und zusätzlich einen elektrischen Vorwiderstand R9 aufweist und der Operationsverstärker der Steuereinrichtung 225 detaillierter dargestellt ist.

Der Begrenzungswiderstand R7 ist hinsichtlich eines Widerstandswerts vordefinierbar, um eine Strombegrenzung eines elektrischen Ausgangsstromes der Überspannungsschutzschaltung 120 einzustellen. Ein erster Anschluss des Begrenzungswiderstands R7 ist mit dem Eingangsanschluss 122 verbunden. Ein zweiter Anschluss des Begrenzungswiderstands R7 ist mit der Regulierungseinrichtung 227 verbunden, genauer gesagt mit dem ersten Anschluss des Transistors T1 der Regulierungseinrichtung 227.

Der als Transistor, genauer gesagt als npn-Transistor, ausgeführte Schalter S1 der Modifizierungseinrichtung 229 weist einen ersten Anschluss, einen zweiten Anschluss und einen Steueranschluss auf. Der erste Anschluss des Schalters S1 ist mit Bezugspotenzial verbunden. Der zweite Anschluss des Schalters S1 ist mit dem Modifizierungswiderstand R3 verbunden. Der Steueranschluss des Schalters S1 ist über den Vorwiderstand R9 mit dem Testanschluss TST verbunden. Somit ist der Vorwiderstand R9 zwischen den Testanschluss TST und den Steueranschluss des Schalters S1 geschaltet.

Die Referenzeinrichtung 221 weist gemäß dem hier dargestellten Ausführungsbeispiel einen Referenzwiderstand R8, eine erste Diode D1 und eine zweite Diode D2 auf. Ein Referenzknoten REF zwischen der ersten Diode D1 und der zweiten Diode D2 ist mit der Steuereinrichtung 225 verbunden. An dem Referenzknoten REF liegt die Referenzspannung U_{ref} an. Gemäß dem hier dargestellten Ausführungsbeispiel sind der Referenzwiderstand R8, die erste Diode D1 und die zweite Diode D2 miteinander in Reihe zwischen einen Steueranschluss 330 zum Anlegen einer elektrischen Steuerspannung Uₛ und Bezugspotenzial geschaltet. Insbesondere ist gemäß dem hier dargestellten Ausführungsbeispiel die erste Diode D1 zwischen den Referenzwiderstand R8 und die zweite Diode D2 bzw. den Referenzknoten REF geschaltet. Gemäß einem alternativen Ausführungsbeispiel kann der Steueranschluss 330 weggelassen sein, wobei der Referenzwiderstand R8, die erste Diode D1 und die zweite Diode D2 miteinander in Reihe zwischen den Eingangsanschluss 122 und Bezugspotenzial geschaltet sind.

Der Operationsverstärker der Steuereinrichtung 225 weist gemäß dem hier dargestellten Ausführungsbeispiel einen ersten Verstärkerkondensator C1, einen zweiten Verstärkerkondensator C2, einen ersten elektrischen Verstärkerwiderstand R4, einen zweiten elektrischen Verstärkerwiderstand R6, einen dritten elektrischen Verstärkerwiderstand R5, einen pnp-Verstärkertransistor T2, einen ersten npn-Verstärkertransistor T3 und einen zweiten npn-Verstärkertransistor T4 auf.

Der invertierende Eingang des Operationsverstärkers ist als ein Steueranschluss des ersten npn-Verstärkertransistors T3 ausgeführt. Der nicht-invertierende Eingang des Operationsverstärkers ist als ein Steueranschluss des zweiten npn-Verstärkertransistors T4 ausgeführt. Ein erster Anschluss des ersten npn-Verstärkertransistors T3 und ein erster Anschluss des zweiten npn-Verstärkertransistors T4 sind über den ersten Verstärkerwiderstand R4 mit Bezugspotenzial verbunden. Ein zweiter Anschluss des ersten npn-Verstärkertransistors T3 ist mit einem zweiten Anschluss des pnp-Verstärkertransistors T2 verbunden. Ferner ist der zweite Anschluss des ersten npn-Verstärkertransistors T3 zum Bereitstellen des Regulierungssignals mit der Regulierungseinrichtung 227 verbunden, genauer gesagt mit dem Steuereingang des Transistors T1 der Regulierungseinrichtung 227. Ein zweiter Anschluss des zweiten npn-Verstärkertransistors T4 ist mit dem Ausgangsanschluss 124 verbunden. Ein erster Anschluss des pnp-Verstärkertransistors T2 ist mit dem Eingangsanschluss 122 verbunden. Ein Steueranschluss des pnp-Verstärkertransistors T2 ist über den zweiten Verstärkerwiderstand R6 mit der Regulierungseinrichtung 227 verbunden, genauer gesagt mit dem ersten Eingang des Transistors T1 der Regulierungseinrichtung 227.

Ein erster Anschluss des ersten Verstärkerkondensators C1 des Operationsverstärkers ist mit dem Eingangsanschluss 122 verbunden. Ein zweiter Anschluss des ersten Verstärkerkondensators C1 ist zwischen den Steueranschluss des pnp-Verstärkertransistors T2 und den zweiten Verstärkerwiderstand R6 geschaltet. Ein erster Anschluss des dritten Verstärkerwiderstands R5 ist mit dem Steueranschluss des ersten npn-Verstärkertransistors T3 verbunden. Ein zweiter Anschluss des dritten Verstärkerwiderstands R5 ist mit dem Ausgangsanschluss 124 verbunden. Ein erster Anschluss des zweiten Verstärkerkondensators C2 ist mit dem Steueranschluss des ersten npn-Verstärkertransistors T3 verbunden. Ein zweiter Anschluss des zweiten Verstärkerkondensators C2 ist mit Bezugspotenzial verbunden.

Nachfolgend werden für einige Bauelemente der Überspannungsschutzschaltung 120 lediglich beispielhafte Parameter dargestellt. Der erste Verstärkerkondensator C1 kann einen Kapazitätswert von 1 Nanofarad aufweisen. Der zweite Verstärkerkondensator C2 kann einen Kapazitätswert von 100 Nanofarad aufweisen. Der erste Teilungswiderstand R1 können einen Widerstandswert von 23,7 Kiloohm aufweisen. Der zweite Teilungswiderstand R2 kann einen Widerstandswert von 10 Kiloohm aufweisen. Der Modifizierungswiderstand R3 kann einen Widerstandswert von 6,81 Kiloohm aufweisen.

Der erste Verstärkerwiderstand R4 kann einen Widerstandswert von 750 Ohm aufweisen. Der zweite Verstärkerwiderstand R6 kann einen Widerstandswert von 100 Ohm aufweisen. Der dritte Verstärkerwiderstand R5 kann einen Widerstandswert von 26,1 Kiloohm aufweisen. Der Referenzwiderstand R8 kann einen Widerstandswert von 26,1 Kiloohm aufweisen. Der Vorwiderstand R9 kann einen Widerstandswert von 10 Kiloohm aufweisen.

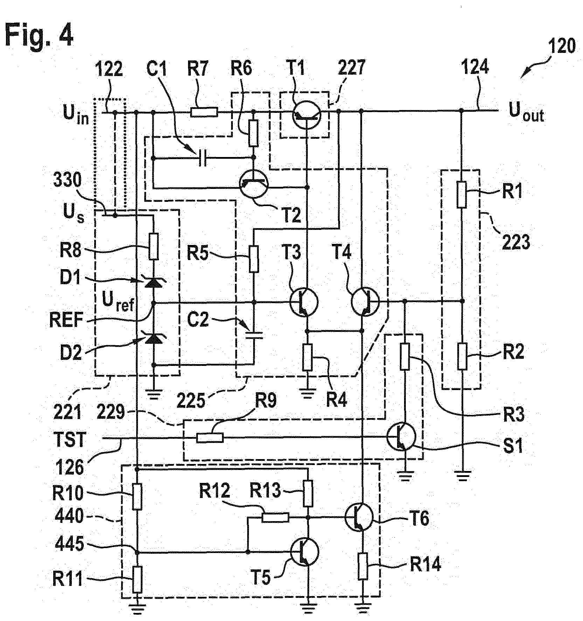

**Fig. 4** zeigt ein schematisches Schaltbild der Überspannungsschutzschaltung 120 aus Fig. 3 mit einer Einstelleinrichtung 440 gemäß einem Ausführungsbeispiel. Mit Ausnahme der gemäß dem in Fig. 4 dargestellten Ausführungsbeispiel zusätzlich vorgesehenen Einstelleinrichtung 440 entspricht die Überspannungsschutzschaltung 120 der Überspannungsschutzschaltung aus Fig. 3. Die Einstelleinrichtung 440 weist einen Einstellknoten 445, einen ersten elektrischen Einstellwiderstand R14, einen zweiten elektrischen Einstellwiderstand R10, einen dritten elektrischen Einstellwiderstand R11, einen vierten elektrischen Einstellwiderstand R12, einen fünften elektrischen Einstellwiderstand R13, einen ersten npn-Einstelltransistor T6 und einen zweiten npn-Einstelltransistor T5 auf.

Die Einstelleinrichtung 440 ist ausgebildet, um das Regulierungssignal unter Verwendung der Eingangsspannung Uᵢₙ einzustellen. Die Einstelleinrichtung 440 weist eine Reihenschaltung aus einem Schalter in Gestalt des ersten npn-Einstelltransistors T6 und dem ersten elektrischen Einstellwiderstand R14 auf. Diese Reihenschaltung ist zwischen die Steuereinrichtung 225 und Bezugspotenzial geschaltet. Der erste npn-Einstelltransistor T6 bzw. Schalter ist abhängig von der Eingangsspannung Uᵢₙ schaltbar.

Ein erster Anschluss des ersten npn-Einstelltransistors T6 ist mit einem ersten Anschluss des ersten Einstellwiderstands R14 verbunden. Ein zweiter Anschluss des ersten Einstellwiderstands R14 ist mit Bezugspotenzial verbunden. Ein zweiter Anschluss des ersten npn-Einstelltransistors T6 ist mit der Steuereinrichtung 225 verbunden, genauer gesagt mit dem ersten Anschluss des zweiten npn-Verstärkertransistors T4 des Operationsverstärkers der Steuereinrichtung 225. Ein Steueranschluss des ersten npn-Einstelltransistors T6 ist mit einem zweiten Anschluss des zweiten npn-Einstelltransistors T5 verbunden. Der erste Anschluss des zweiten npn-Einstelltransistors T5 ist mit Bezugspotenzial verbunden. Der zweite Einstellwiderstand R10 und der dritte Einstellwiderstand R11 sind miteinander in Reihe zwischen den Eingangsanschluss 122 und Bezugspotenzial geschaltet. Der Einstellknoten 445 ist zwischen dem zweiten Einstellwiderstand R10 und dem dritten Einstellwiderstand R11 angeordnet. Ein Steueranschluss des zweiten npn-Einstelltransistors T5 ist mit dem Einstellknoten 445 verbunden. Ein erster Anschluss des vierten Einstellwiderstands R12 ist mit dem Einstellknoten 445 verbunden. Ein zweiter Anschluss des vierten Einstellwiderstands R12 ist mit dem zweiten Anschluss des zweiten npn-Einstelltransistors T5 verbunden. Ein erster Anschluss des fünften Einstellwiderstands R13 ist mit dem zweiten Anschluss des zweiten npn-Einstelltransistors T5 verbunden. Ein zweiter Anschluss des fünften Einstellwiderstands ist R13 mit dem Eingangsanschluss 122 verbunden.

Nachfolgend werden für einige Bauelemente der Einstelleinrichtung 440 der Überspannungsschutzschaltung 120 lediglich beispielhafte Parameter dargestellt. Der erste Einstellwiderstand R14 kann einen Widerstandswert von 60 Ohm aufweisen. Der zweite Einstellwiderstand R10 kann einen Widerstandswert von 100 Kiloohm aufweisen. Der dritte Einstellwiderstand R11 kann einen Widerstandswert von 3,83 Kiloohm aufweisen. Der vierte Einstellwiderstand R12 kann einen Widerstandswert von 21,5 Kiloohm aufweisen. Der fünfte Einstellwiderstand R13 kann einen Widerstandswert von 51,1 Kiloohm aufweisen.

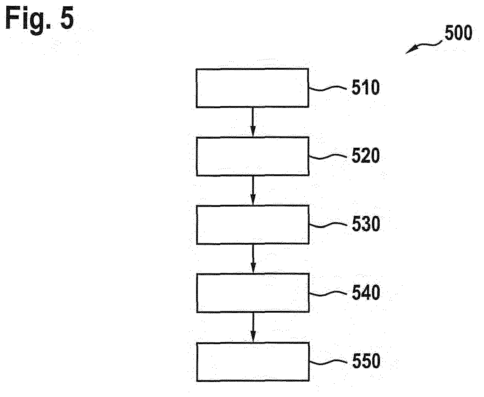

**Fig. 5** zeigt ein Ablaufdiagramm eines Verfahrens 500 zum Testen gemäß einem Ausführungsbeispiel. Das Verfahren 500 zum Testen ist ausführbar, um eine Überspannungsschutzschaltung für ein Steuergerät für ein Fahrzeug zu testen. Genauer gesagt ist das Verfahren 500 zum Testen ausführbar, um die Überspannungsschutzschaltung aus einer der vorstehend beschriebenen Figuren oder eine ähnliche Überspannungsschutzschaltung zu testen.

Das Verfahren 500 kann beispielsweise unter Verwendung einer Testeinrichtung durchgeführt werden, wie sie anhand von Fig. 1 beschrieben ist.

Dabei wird in einem ersten Schritt 510 des Anlegens eine elektrische Testspannung mit einem ersten Spannungspegel an den Testanschluss der Überspannungsschutzschaltung angelegt. Nachfolgend wird in einem ersten Schritt 520 des Erfassens eine erste elektrische Ausgangsspannung ansprechend auf die elektrische Testspannung mit dem ersten Spannungspegel erfasst. Wiederum nachfolgend wird in einem zweiten Schritt 530 des Anlegens eine elektrische Testspannung mit einem zweiten Spannungspegel an den Testanschluss der Überspannungsschutzschaltung angelegt. Der zweite Spannungspegel ist niedriger als der erste Spannungspegel. Nachfolgend wird in einem zweiten Schritt 540 des Erfassens eine zweite elektrische Ausgangsspannung ansprechend auf die elektrische Testspannung mit dem zweiten Spannungspegel erfasst. In einem Schritt 550 des Überprüfens wird schließlich überprüft, ob die erfasste erste Ausgangsspannung und die erfasste zweite Ausgangsspannung zumindest ein Testkriterium erfüllen, um ein Testergebnis zu erzeugen.

Nachfolgend wird eine kurze Funktionsbeschreibung von Ausführungsbeispielen der vorliegenden Erfindung unter Bezugnahme auf die vorstehend beschriebenen Figuren abgegeben.

Wird an den Testeingang 126 eine Testspannung TST mit dem ersten Spannungspegel von beispielsweise über 1, 5 Volt angeschlossen, so wird der Schalter S1 der Modifizierungseinrichtung 229 geschlossen und die Ausgangsspannung Uₒᵤₜ wird beispielsweise auf (U_{ref} - 0,65V) x (R1 + R2 || R3) / R1 begrenzt. Der Spannungswert 0,65V ist dabei ein typischer jedoch beispielhafter Wert, der sich aus der Charakteristik der verwendeten Schaltungselemente ergibt. Unterhalb dieses Spannungswertes bzw. dieser Begrenzerspannung folgt die Ausgangsspannung Uₒᵤₜ der Eingangsspannung Uᵢₙ, sodass gilt: Uₒᵤₜ = Uᵢₙ - Spannungsabfall über dem Begrenzungswiderstand R7 und dem Transistor T1 der Regulierungseinrichtung 227.

Wird an den Testeingang 126 eine Testspannung TST mit dem zweiten Spannungspegel von beispielsweise unter 0,4 Volt angeschlossen, so wird Schalter S1 der Modifizierungseinrichtung 229 geöffnet und die Ausgangsspannung Uₒᵤₜ wird beispielsweise auf (Uref - 0.65V) x (R1 + R2) / R1 begrenzt. Unterhalb dieses Spannungswertes bzw. dieser Begrenzerspannung folgt die Ausgangsspannung Uₒᵤₜ der Eingangsspannung Uᵢₙ, sodass gilt: Uₒᵤₜ = Uᵢₙ - Spannungsabfall über dem Begrenzungswiderstand R7 und dem Transistor T1 der Regulierungseinrichtung 227.

Somit wird die Ausgangsspannung Uₒᵤₜ für den Fall eines geschlossenen Schalters S1 auf einen ersten Spannungswert begrenzt, der von der Referenzspannung U_{ref}, den Werten der Widerstände R1, R2, R3 sowie einem spezifischen Spannungswert der verwendeten Schaltungselemente abhängig ist.

Entsprechend wird die Ausgangsspannung Uₒᵤₜ für den Fall eines geöffneten Schalters S1 auf einen sich von dem ersten Spannungswert unterscheidenden zweiten Spannungswert begrenzt, der von der Referenzspannung U_{ref}, den Werten der Widerstände R1, R2 sowie dem spezifischen Spannungswert der verwendeten Schaltungselemente abhängig ist.

Wird die Ausgangsspannung Uₒᵤₜ gemessen, so kann die Funktion der Überspannungsschutzschaltung 120 ab einer Eingangsspannung Uᵢₙ größer als die niedrigere Begrenzerspannung der vorstehend beschriebenen Begrenzerspannungen zuzüglich dem Spannungsabfall über dem Begrenzungswiderstand R7 und dem Transistor T1 der Regulierungseinrichtung 227getestet werden.

Bei der Überspannungsschutzschaltung 120 bestehen eine Einschalthysterese, welche über die erste Diode D1 einstellbar ist, sowie eine Strombegrenzung eines Ausgangsstromes, welcher über den Begrenzungswiderstand R7 einstellbar ist.

Die Steuerspannung Uₛ kann mit der Eingangsspannung Uᵢₙ verbunden sein oder als separater Schalteingang bzw. Steueranschluss 330 verwendet werden. Dieser Steueranschluss 330 kann zum Beispiel mit einer Klemme des Fahrzeugs 100 verbunden sein oder werden.

Die Einstelleinrichtung 440 repräsentiert einen Schaltungsteil, welcher die Einstellwiderstände R10 bis R14 und die Transistoren T5 und T6 aufweist und ausgebildet ist, um das Regulierungssignal bzw. einen Basisstrom des Transistors T1 der Regulierungseinrichtung 227 in Abhängigkeit von der Eingangsspannung Uᵢₙ zu steuern. Damit ist es möglich, bei niedriger Eingangsspannung Uᵢₙ einen hohen oder höheren Basisstrom des Transistors T1 als Regulierungssignal und bei hoher Eingangsspannung Uᵢₙ einen niedrigen oder niedrigeren Basisstrom des Transistors T1 als Regulierungssignal zu erzeugen, ohne den ersten npn-Verstärkertransistor T3 zu überlasten. Dies ist besonders vorteilhaft, wenn die Ausgangsspannung Uₒᵤₜ einen Schaltregler des Steuergeräts 110 versorgt, welcher bei niedrigen Versorgungsspannungen einen hohen Eingangsstrombedarf und bei hohen Versorgungsspannungen einen niedrigeren Eingangsstrombedarf hat.

### BEZUGSZEICHENLISTE

- 100: Fahrzeug
- 102: Batterie
- 110: Steuergerät
- 112: Steuergeräteeinrichtung
- 114: Spannungsversorgungsanschluss
- 120: Überspannungsschutzschaltung
- 122: Eingangsanschluss
- 124: Ausgangsanschluss
- 126: Testanschluss
- 130: Testeinrichtung
- 132: Testsignal
- Uᵢₙ: Eingangsspannung
- Uₒᵤₜ: Ausgangsspannung
- TST: Testspannung

- 221: Referenzeinrichtung
- 223: Teilungseinrichtung
- 225: Steuereinrichtung
- 227: Regulierungseinrichtung
- 229: Modifizierungseinrichtung
- R1: erster elektrischer Teilungswiderstand
- R2: zweiter elektrischer Teilungswiderstand
- R3: elektrischer Modifizierungswiderstand
- S1: Schalter
- T1: Transistor
- U_{ref}: Referenzspannung

- 330: Steueranschluss
- C1: erster Verstärkerkondensator
- C2: zweiter Verstärkerkondensator
- D1: erste Diode
- D2: zweite Diode
- REF: Referenzknoten
- R4: erster elektrischer Verstärkerwiderstand
- R5: dritter elektrischer Verstärkerwiderstand
- R6: zweiter elektrischer Verstärkerwiderstand
- R7: elektrischer Begrenzungswiderstand
- R8: elektrischer Referenzwiderstand
- R9: elektrischer Vorwiderstand
- T2: pnp-Verstärkertransistor
- T3: erster npn-Verstärkertransistor
- T4: zweiter npn-Verstärkertransistor
- Uₛ: Steuerspannung

- 440: Einstelleinrichtung
- 445: Einstellknoten
- R10: zweiter elektrischer Einstellwiderstand
- R11: dritter elektrischer Einstellwiderstand
- R12: vierter elektrischer Einstellwiderstand
- R13: fünfter elektrischer Einstellwiderstand
- R14: erster elektrischer Einstellwiderstand
- T5: zweiter npn-Einstelltransistor
- T6: erster npn-Einstelltransistor

- 500: Verfahren zum Testen
- 510: erster Schritt des Anlegens
- 520: erster Schritt des Erfassens
- 530: zweiter Schritt des Anlegens
- 540: zweiter Schritt des Erfassens
- 550: Schritt des Überprüfens

## Patentansprüche

1. Überspannungsschutzschaltung (120) für ein Steuergerät (110) für ein Fahrzeug (100), wobei die Überspannungsschutzschaltung (120) folgende Merkmale aufweist:
einen Eingangsanschluss (122) zum Anlegen einer elektrischen Eingangsspannung (Uᵢₙ), einen Testanschluss (126) zum Anlegen einer elektrischen Testspannung (TST) und einen Ausgangsanschluss (124) zum Bereitstellen einer elektrischen Ausgangsspannung (Uₒᵤₜ) zum Versorgen des Steuergeräts (110);
eine Referenzeinrichtung (221), die ausgebildet ist, um unter Verwendung der Eingangsspannung (Uᵢₙ) eine Referenzspannung (U_{ref}) bereitzustellen;
eine Teilungseinrichtung (223), die ausgebildet ist, um unter Verwendung der Ausgangsspannung (Uₒᵤₜ) eine Teilspannung bereitzustellen, wobei die Teilungseinrichtung (223) einen ersten elektrischen Teilungswiderstand (R1) und einen zweiten elektrischen Teilungswiderstand (R2) aufweist, wobei ein erster Anschluss des ersten Teilungswiderstands (R1) mit dem Ausgangsanschluss (124) verbunden ist, wobei ein zweiter Anschluss des ersten Teilungswiderstands (R1) mit einem ersten Anschluss des zweiten Teilungswiderstands (R2) verbunden ist, wobei ein zweiter Anschluss des zweiten Teilungswiderstands (R2) mit Bezugspotenzial verbunden ist, wobei der zweite Anschluss des ersten Teilungswiderstands (R1) zum Bereitstellen der Teilspannung mit der Steuereinrichtung (225) verbunden ist;
eine Steuereinrichtung (225), die ausgebildet ist, um unter Verwendung der Referenzspannung (U_{ref}) und der Teilspannung ein Regulierungssignal bereitzustellen, wobei die Steuereinrichtung (225) einen Operationsverstärker mit einem invertierenden Eingang, einem nicht-invertierenden Eingang und einem Ausgang aufweist, wobei der invertierende Eingang des Operationsverstärkers zum Empfangen der Referenzspannung (U_{ref}) mit der Referenzeinrichtung (221) verbunden ist, wobei der nicht-invertierende Eingang des Operationsverstärkers zum Empfangen der Teilspannung mit der Teilungseinrichtung (223) und zum Modifizieren der Teilspannung mit der Modifizierungseinrichtung (229) verbunden ist, wobei der Ausgang des Operationsverstärkers zum Bereitstellen des Regulierungssignals mit der Regulierungseinrichtung (227) verbunden ist;
eine Regulierungseinrichtung (227), die zwischen den Eingangsanschluss (122) und den Ausgangsanschluss (124) geschaltet ist, wobei die Regulierungseinrichtung (227) ausgebildet ist, um die Ausgangsspannung (Uₒᵤₜ) unter Verwendung der Eingangsspannung (Uᵢₙ) und des Regulierungssignals bereitzustellen; und
eine Modifizierungseinrichtung (229), die ausgebildet ist, um einen Wert der Teilspannung unter Verwendung der Testspannung (TST) zu modifizieren, wobei die Modifizierungseinrichtung (229) einen Schalter (S1) und einen elektrischen Modifizierungswiderstand (R3) aufweist, wobei der Schalter (S1) und der Modifizierungswiderstand (R3) miteinander in Reihe zwischen Bezugspotenzial und den nicht-invertierenden Eingang des Operationsverstärkers der Steuereinrichtung (225) geschaltet sind, wobei ein Steueranschluss des Schalters (S1) mit dem Testanschluss (126) verbunden ist.

2. Überspannungsschutzschaltung (120) gemäß Anspruch 1, bei der die Regulierungseinrichtung (227) einen Transistor (T1) mit einem ersten Anschluss, einem zweiten Anschluss und einem Steueranschluss zum Empfangen des Regulierungssignals aufweist, wobei der erste Anschluss des Transistors (T1) mit dem Eingangsanschluss (122) verbunden ist, wobei der zweite Anschluss des Transistors (T1) mit dem Ausgangsanschluss (124) verbunden ist, wobei der Steueranschluss des Transistors (T1) mit der Steuereinrichtung (225) verbunden ist.

3. Überspannungsschutzschaltung (120) gemäß einem der vorangegangenen Ansprüche, bei der die Referenzeinrichtung (221) einen Referenzwiderstand (R8), eine erste Diode (D1) und eine zweite Diode (D2) aufweist, wobei der Referenzwiderstand (R8), die erste Diode (D1) und die zweite Diode (D2) miteinander in Reihe zwischen einen Steueranschluss (330) zum Anlegen einer elektrischen Steuerspannung (Uₛ) und Bezugspotenzial oder zwischen den Eingangsanschluss (122) und Bezugspotenzial geschaltet sind, wobei ein Referenzknoten (REF) zwischen der ersten Diode (D1) und der zweiten Diode (D2) mit der Steuereinrichtung (225) verbunden ist.

4. Überspannungsschutzschaltung (120) gemäß einem der vorangegangenen Ansprüche, bei der der Operationsverstärker zwei npn-Verstärkertransistoren (T3, T4), einen pnp-Verstärkertransistor (T2), zwei Verstärkerkondensatoren (C1, C2) und drei elektrische Verstärkerwiderstände (R4, R5, R6) aufweist, wobei der invertierende Eingang des Operationsverstärkers als ein Steueranschluss eines ersten (T3) der npn-Verstärkertransistoren (T3, T4) ausgeführt ist, wobei der nicht-invertierende Eingang des Operationsverstärkers als ein Steueranschluss eines zweiten (T4) der npn-Verstärkertransistoren (T3, T4) ausgeführt ist, wobei ein erster Anschluss des ersten (T3) der npn-Verstärkertransistoren (T3, T4) und ein erster Anschluss des zweiten (T4) der npn-Verstärkertransistoren (T3, T4) über einen ersten (R4) der Verstärkerwiderstände (R4, R5, R6) mit Bezugspotenzial verbunden sind, wobei ein zweiter Anschluss des ersten (T3) der npn-Verstärkertransistoren (T3, T4) mit einem zweiten Anschluss des pnp-Verstärkertransistors (T2) und zum Bereitstellen des Regulierungssignals mit der Regulierungseinrichtung (227) verbunden ist, wobei ein zweiter Anschluss des zweiten (T4) der npn-Verstärkertransistoren (T3, T4) mit dem Ausgangsanschluss (124) verbunden ist, wobei ein erster Anschluss des pnp-Verstärkertransistors (T2) mit dem Eingangsanschluss (122) verbunden ist, wobei ein Steueranschluss des pnp-Verstärkertransistors (T2) über einen zweiten (R6) der Verstärkerwiderstände (R4, R5, R6) mit der Regulierungseinrichtung (227) verbunden ist, wobei ein erster Anschluss eines ersten (C1) der Verstärkerkondensatoren (C1, C2) mit dem Eingangsanschluss (122) verbunden ist, wobei ein zweiter Anschluss des ersten (C1) der Verstärkerkondensatoren (C1, C2) zwischen den Steueranschluss des pnp-Verstärkertransistors (T2) und den zweiten (R6) der Verstärkerwiderstände (R4, R5, R6) geschaltet ist, wobei ein erster Anschluss eines dritten (R5) der Verstärkerwiderstände (R4, R5, R6) mit dem Steueranschluss des ersten (T3) der npn-Verstärkertransistoren (T3, T4) verbunden ist, wobei ein zweiter Anschluss des dritten (R5) der Verstärkerwiderstände (R4, R5, R6) mit dem Ausgangsanschluss (124) verbunden ist, wobei ein erster Anschluss eines zweiten (C2) der Verstärkerkondensatoren (C1, C2) mit dem Steueranschluss des ersten (T3) der npn-Verstärkertransistoren (T3, T4) verbunden ist, wobei ein zweiter Anschluss des zweiten (C2) der Verstärkerkondensatoren (C1, C2) mit Bezugspotenzial verbunden ist.

5. Überspannungsschutzschaltung (120) gemäß einem der vorangegangenen Ansprüche, mit einer Einstelleinrichtung (440) zum Einstellen des Regulierungssignals unter Verwendung der Eingangsspannung (Uᵢₙ), wobei die Einstelleinrichtung (440) eine Reihenschaltung aus einem Schalter und einem ersten elektrischen Einstellwiderstand (R14) aufweist, die zwischen die Steuereinrichtung (225) und Bezugspotenzial geschaltet ist, wobei der Schalter abhängig von der Eingangsspannung (Uᵢₙ) schaltbar ist.

6. Überspannungsschutzschaltung (120) gemäß Anspruch 5, bei der der Schalter als ein erster npn-Einstelltransistor (T6) ausgeführt ist, wobei die Einstelleinrichtung (440) ferner einen zweiten npn-Einstelltransistor (T5), einen zweiten Einstellwiderstand (R10), einen dritten Einstellwiderstand (R11), einen vierten Einstellwiderstand (R12) und einen fünften Einstellwiderstand (R13) aufweist, wobei ein erster Anschluss des ersten npn-Einstelltransistors (T6) mit einem ersten Anschluss des ersten Einstellwiderstands (R14) verbunden ist, wobei ein zweiter Anschluss des ersten Einstellwiderstands (R14) mit Bezugspotenzial verbunden ist, wobei ein zweiter Anschluss des ersten npn-Einstelltransistors (T6) mit der Steuereinrichtung (225) verbunden ist, wobei ein Steueranschluss des ersten npn-Einstelltransistors (T6) mit einem zweiten Anschluss des zweiten npn-Einstelltransistors (T5) verbunden ist, wobei der erste Anschluss des zweiten npn-Einstelltransistors (T5) mit Bezugspotenzial verbunden ist, wobei der zweite Einstellwiderstand (R10) und der dritte Einstellwiderstand (R11) miteinander in Reihe zwischen den Eingangsanschluss (122) und Bezugspotenzial geschaltet sind, wobei ein Steueranschluss des zweiten npn-Einstelltransistors (T5) mit einem Einstellknoten (445) zwischen dem zweiten Einstellwiderstand (R10) und dem dritten Einstellwiderstand (R11) verbunden ist, wobei ein erster Anschluss des vierten Einstellwiderstands (R12) mit dem Einstellknoten (445) verbunden ist, wobei ein zweiter Anschluss des vierten Einstellwiderstands (R12) mit dem zweiten Anschluss des zweiten npn-Einstelltransistors (T5) verbunden ist, wobei ein erster Anschluss des fünften Einstellwiderstands (R13) mit dem zweiten Anschluss des zweiten npn-Einstelltransistors (T5) verbunden ist, wobei ein zweiter Anschluss des fünften Einstellwiderstands (R13) mit dem Eingangsanschluss (122) verbunden ist.

7. Überspannungsschutzschaltung (120) gemäß einem der vorangegangenen Ansprüche, mit einem elektrischen Begrenzungswiderstand (R7), wobei ein erster Anschluss des Begrenzungswiderstands (R7) mit dem Eingangsanschluss (122) verbunden ist, wobei ein zweiter Anschluss des Begrenzungswiderstands (R7) mit der Regulierungseinrichtung (227) verbunden ist.

8. Steuergerät (110) für ein Fahrzeug (100), wobei das Steuergerät (110) eine Überspannungsschutzschaltung (120) gemäß einem der vorangegangenen Ansprüche und einen Spannungsversorgungsanschluss (114) aufweist, wobei der Ausgangsanschluss (124) der Überspannungsschutzschaltung (120) mit dem Spannungsversorgungsanschluss (114) des Steuergerätes (110) verbunden ist.

9. Steuergerät (110) gemäß Anspruch 8, mit einer Testeinrichtung (130) zum Testen einer Funktionalität der Überspannungsschutzschaltung (120), wobei die Testeinrichtung (130) ausgebildet ist, um einen ersten Wert oder ersten Werteverlauf der elektrischen Ausgangsspannung (Uₒᵤₜ) zu erfassen während an dem Testanschluss (126) die einen ersten Spannungspegel aufweisende elektrischen Testspannung (TST) anliegt, einen zweiten Wert oder zweiten Werteverlauf der elektrischen Ausgangsspannung (Uₒᵤₜ) zu erfassen während an dem Testanschluss (126) die einen zweiten Spannungspegel aufweisende elektrischen Testspannung (TST), und ausgebildet ist, um unter Verwendung des ersten Werts oder ersten Werteverlaufs sowie des zweiten Werts oder zweiten Werteverlaufs ein Testsignal (132) bereitzustellen.

10. Verfahren (500) zum Testen einer Überspannungsschutzschaltung (120) für ein Steuergerät (110) für ein Fahrzeug (100), wobei die Überspannungsschutzschaltung (120) eine Überspannungsschutzschaltung (120) gemäß einem der Ansprüche 1 bis 7 ist, wobei das Verfahren (500) folgende Schritte aufweist:
Anlegen (510) einer elektrischen Testspannung (TST) mit einem ersten Spannungspegel an den Testanschluss (126) der Überspannungsschutzschaltung (120);
Erfassen (520) einer ersten elektrischen Ausgangsspannung (Uₒᵤₜ) ansprechend auf die elektrische Testspannung (TST) mit dem ersten Spannungspegel;
Anlegen (530) einer elektrischen Testspannung (TST) mit einem zweiten Spannungspegel an den Testanschluss (126) der Überspannungsschutzschaltung (120), wobei der zweite Spannungspegel niedriger als der erste Spannungspegel ist;
Erfassen (540) einer zweiten elektrischen Ausgangsspannung (Uₒᵤₜ) ansprechend auf die elektrische Testspannung (TST) mit dem zweiten Spannungspegel;
Überprüfen (550), ob die erfasste erste Ausgangsspannung (Uₒᵤₜ) und die erfasste zweite Ausgangsspannung (Uₒᵤₜ) zumindest ein Testkriterium erfüllen, um ein Testergebnis zu erzeugen.

## Claims

1. Overvoltage protection circuit (120) for a control unit (110) for a vehicle (100), wherein the overvoltage protection circuit (120) has the following characteristics:
an input terminal (122) for applying an electrical input voltage (Uᵢₙ), a test terminal (126) for applying an electrical test voltage (TST) and an output terminal (124) for providing an electrical output voltage (Uₒᵤₜ) for supplying the control unit (110);
a reference device (221) which is configured to use the input voltage (Uᵢₙ)to provide a reference voltage (Uₒᵤₜ);
a splitting device (223) which is configured to use the output voltage (Uₒᵤₜ) to provide a partial voltage, wherein the splitting device (223) has a first electrical splitting resistance (R1) and a second electrical splitting resistance (R2), wherein a first terminal of the first splitting resistance (R1) is connected to the output terminal (124), wherein a second terminal of the first splitting resistance (R1) is connected to a first terminal of the second splitting resistance (R2), wherein a second terminal of the second splitting resistance (R2) is connected to ground potential, wherein the second terminal of the first splitting resistance (R1) is connected to the control unit (225) for providing the partial voltage;
a control apparatus (225) which is configured to use the reference voltage (U_{ref}) and the partial voltage to provide a regulating signal, wherein the control apparatus (225) has an operational amplifier having an inverting input, a non-inverting input and an output, wherein the inverting input of the operational amplifier is connected to the reference device (221) for receiving the reference voltage (U_{ref}), wherein the non-inverting input of the operational amplifier is connected to the splitting device (223) for receiving the partial voltage and with the modifying apparatus (229) for modifying the partial voltage, wherein the output of the operational amplifier is connected to the regulating apparatus (227) for providing the regulating signal;
a regulating apparatus (227), which is connected between the input terminal (122) and the output terminal (124), wherein the regulating apparatus (227) is configured to use the input voltage (Uᵢₙ) and the regulating signal provide the output voltage (Uₒᵤₜ); and
a modifying apparatus (229), which is configured to use the test voltage (TST) to modify a value of the partial voltage, wherein the modifying apparatus (229) has a switch (S1) and an electrical modification resistance (R3), wherein the switch (51) and the modification resistance (R3) are connected to one another in series between ground potential and the non-inverting input of the operational amplifier of the control apparatus (225), wherein a control terminal of the switch (S1) is connected to the test terminal (126).

2. Overvoltage protection circuit (120) according to claim 1, in which the regulating apparatus (227) has a transistor (T1) having a first terminal, a second terminal and a control terminal for receiving the regulating signal, wherein the first terminal of the transistor (T1) is connected to the input terminal (122), wherein the second terminal of the transistor (T1) is connected to the output terminal (124), wherein the control terminal of the transistor (T1) is connected to the control apparatus (225).

3. Overvoltage protection circuit (120) according to any of the preceding claims, in which the reference device (221) has a reference resistance (R8), a first diode (D1) and a second diode (D2), wherein the reference resistance (R8), the first diode (D1) and the second diode (D2) are connected to one another in series between a control terminal (330) for applying an electrical control voltage (Us) and ground potential, or between the input terminal (122) and ground potential, wherein a reference node (REF) is connected to the control apparatus (225) between the first diode (D1) and the second diode (D2).

4. Overvoltage protection circuit (120) according to any of the preceding claims, in which the operational amplifier has two non-amplifier transistors (T3, T4), a pnp-amplifier transistor (T2), two amplifier capacitors (C1, C2) and three electrical amplifier resistances (R4, R5, R6), wherein the inverting input of the operational amplifier is designed as a control terminal of a first one (T3) of the npn-amplifier transistors (T3, T4), wherein the non-inverting input of the operational amplifier is designed as a control terminal of a second one (T4) of the npn-amplifier transistors (T3, T4), wherein a first terminal of the first one (T3) of the npn-amplifier transistors (T3, T4) and a first terminal of the second one (T4) of the npn-amplifier transistors (T3, T4) are connected to ground potential via a first one (R4) of the amplifier resistances (R4, R5, R6), wherein a second terminal of the first one (T3) of the npn-amplifier transistors (T3, T4) is connected to a second terminal of the pnp-amplifier transistor (T2) and, for providing the regulating signal, with the regulating apparatus (227), wherein a second terminal of the second one (T4) of the npn-amplifier transistors (T3, T4) is connected to the output terminal (124), wherein a first terminal of the pnp-amplifier transistor (T2) is connected to the input terminal (122), wherein a control terminal of the pnp-amplifier transistor (T2) is connected to the regulating apparatus (227) via a second one (R6) of the amplifier resistances (R4, R5, R6), wherein a first terminal of a first one (C1) of the amplifier capacitors (C1, C2) is connected to the input terminal (122), wherein a second terminal of the first one (C1) of the amplifier capacitors (C1, C2) is connected between the control terminal of the pnp-amplifier transistor (T2) and the second one (R6) of the amplifier resistances (R4, R5, R6), wherein a first terminal of a third one (R5) of the amplifier resistances (R4, R5, R6) is connected to the control terminal of the first one (T3) of the npn- amplifier transistors (T3, T4), wherein a second terminal of the third one (R5) of the amplifier resistances (R4, R5, R6) is connected to the output terminal (124), wherein a first terminal of a second one (C2) of the amplifier capacitors (C1, C2) is connected to the control terminal of the first one (T3) of the npn-amplifier transistors (T3, T4), wherein a second terminal of the second one (C2) of the amplifier capacitors (C1, C2) is connected to ground potential.

5. Overvoltage protection circuit (120) according to any of the preceding claims, having a setting apparatus (440) for using the input voltage (Uᵢₙ) to set the regulating signal, wherein the setting apparatus (440) has a series circuit consisting of a switch and a first electrical setting resistance (R14), which is connected between the control apparatus (225) and ground potential, wherein the switch is switchable independently of the input voltage (Uᵢₙ).

6. Overvoltage protection circuit (120) according to claim 5, in which the switch is designed as a first npn-setting transistor (T6), wherein the setting apparatus (440) furthermore has a second npn-setting transistor (T5), a second setting resistance (R10), a third setting resistance (R11), a fourth setting resistance (R12) and a fifth setting resistance (R13), wherein a first terminal of the first npn-setting transistor (T6) is connected to a first terminal of the first setting resistance (R14), wherein a second terminal of the first setting resistance (R14) is connected to ground potential, wherein a second terminal of the first npn-setting transistor (T6) is connected to the control apparatus (225), wherein a control terminal of the first npn-setting transistor (T6) is connected to a second terminal of the second npn-setting transistor (T5), wherein the first terminal of the second npn-setting transistor (T5) is connected to ground potential, wherein the second setting resistance (R10) and the third setting resistance (R11) are connected together in series between the input terminal (122) and ground potential, wherein a control terminal of the second npn-setting transistor (T5) is connected to a setting node (445) between the second setting resistance (R10) and the third setting resistance (R11), wherein a first terminal of the fourth setting resistance (R12) is connected to the setting node (445), wherein a second terminal of the fourth setting resistance (R12) is connected to the second terminal of the second npn-setting transistor (T5), wherein a first terminal of the fifth setting resistance (R13) is connected to the second terminal of the second npn-setting transistor (T5), wherein a second terminal of the fifth setting resistance (R13) is connected to the input terminal (122).

7. Overvoltage protection circuit (120) according to any of the preceding claims, having an electrical limiting resistance (R7), wherein a first terminal of the limiting resistance (R7) is connected to the input terminal (122), wherein a second terminal of the limiting resistance (R7) is connected to the regulating apparatus (227).

8. Control device (110) for a vehicle (100), wherein the control device (110) has an overvoltage protection circuit (120) according to any of the preceding claims and a voltage supply terminal (114), wherein the output terminal (124) of the overvoltage protection circuit (120) is connected to the voltage supply terminal (114) of the control device (110).

9. Control device (110) according to claim 8 having a testing apparatus (130) for testing a functionality of the overvoltage protection circuit (120), wherein the testing apparatus (130) is configured to detect a first value or first value progression of the electrical output voltage (Uₒᵤₜ) while the electrical testing voltage (TST) having a first voltage level is applied to the testing terminal (126), to detect a second value or second value aggression of the electrical output voltage (Uₒᵤₜ) while the electrical testing voltage (TST) having a second voltage level is applied to the testing terminal (126), in order to use the first value or first value progression, and the second value or second value progression, to provide a testing signal (132).

10. Method (500) for testing an overvoltage protection circuit (120) for a control device (110) for a vehicle (100), wherein the overvoltage protection circuit (120) is an overvoltage protection circuit (120) according to any of claims 1 to 7, wherein the method (500) has the following steps:
applying (510) an electrical testing voltage (TST) having a first voltage level to the testing terminal (126) of the overvoltage protection circuit (120);
detecting (520) a first electrical output voltage (Uₒᵤₜ) responsive to the electrical testing voltage (TST) having the first voltage level;
applying (530) an electrical testing voltage (TST) having a second voltage level to the testing terminal (126) of the overvoltage protection circuit (120), wherein the second voltage level is lower than the first voltage level;
detecting (540) a second electrical output voltage (Uₒᵤₜ) responsive to the electrical testing voltage (TST) having the second voltage level;
verifying (550) whether the detected first output voltage (Uₒᵤₜ) and the detected second output voltage (Uₒᵤₜ) fulfill at least one test criterion in order to generate a test result.

## Revendications

1. Circuit de protection contre les surtensions (120) destiné à un appareil de commande (110) pou un véhicule automobile (100), dans lequel le circuit de protection contre les surtensions (120) présente les caractéristiques suivantes :
une borne d'entrée (122) pour appliquer une tension électrique d'entrée (Uᵢₙ), une borne de test (126) pour appliquer une tension électrique de test (TST) et une borne de sortie (124) pour fournir une tension électrique de sortie (Uₒᵤₜ) afin d'alimenter l'appareil de commande (110) ;
un appareil de référence (221) qui est conçu pour fournir une tension de référence (U_{ref}) en utilisant la tension d'entrée (Uᵢₙ);
un dispositif de séparation (223) qui est conçu pour fournir une tension partielle en utilisant la tension de sortie (Uₒᵤₜ), dans lequel l'appareil de séparation (223) présente une première résistance électrique de séparation (R1) et une seconde résistance électrique de séparation (R2), dans lequel une première borne de la première résistance de séparation (R1) est raccordée à la borne de sortie (124), dans lequel une seconde borne de la première résistance de séparation (R1) est raccordée à une première borne de la seconde résistance de séparation (R2), dans lequel une seconde borne de la seconde résistance de séparation (R2) est raccordée à un potentiel de référence, dans lequel la seconde borne de la première résistance de séparation (R1) est raccordée au dispositif de commande (225) pour fournir la tension partielle ;
un dispositif de commande (225) qui est conçu pour fournir un signal de régulation en utilisant la tension de référence (U_{ref}) et la tension partielle, dans lequel le dispositif de commande (225) présente un amplificateur opérationnel avec une entrée inverseuse, une entrée non inverseuse et une sortie, dans lequel l'entrée inverseuse de l'amplificateur opérationnel est raccordée au dispositif de référence (221) pour recevoir la tension de référence (U_{ref}), dans lequel l'entrée non inverseuse de l'amplificateur opérationnel est raccordée au dispositif de séparation (223) pour recevoir la tension partielle et au dispositif de modification (229) pour modifier la tension partielle, dans lequel la sortie de l'amplificateur opérationnel est raccordée au dispositif de régulation (227) pour fournir le signal de régulation ;
un dispositif de régulation (227) qui est monté entre la borne d'entrée (122) et la borne de sortie (124), dans lequel le dispositif de régulation (227) est conçu pour fournir la tension de sortie (Uₒᵤₜ) en utilisant la tension d'entrée (Uᵢₙ) et le signal de régulation ; et
un dispositif de modification (229) qui est conçu pour modifier une valeur de la tension partielle en utilisant la tension de test (TST), dans lequel le dispositif de modification (229) présente un commutateur (S1) et une résistance électrique de modification (R3), dans lequel le commutateur (S1) et la résistance de modification (R3) sont montés en série l'un avec l'autre entre un potentiel de référence et l'entrée non inverseuse de l'amplificateur opérationnel du dispositif de commande (225), dans lequel une borne de commande du commutateur (S1) est raccordée à la borne de test (126).

2. Circuit de protection contre les surtensions (120) selon la revendication 1, dans lequel le dispositif de régulation (227) présente un transistor (T1) avec une première borne, une seconde borne et une borne de commande pour recevoir le signal de régulation, dans lequel la première borne du transistor (T1) est raccordée à la borne d'entrée (122), dans lequel la seconde borne du transistor (T1) est raccordée à la borne de sortie (124), dans lequel la borne de commande du transistor (T1) est raccordée au dispositif de commande (225).

3. Circuit de protection contre les surtensions (120) selon l'une quelconque des revendications précédentes, dans lequel le dispositif de référence (221) présente une résistance de référence (R8), une première diode (D1) et une seconde diode (D2), dans lequel la résistance de référence (R8), la première diode (D1) et la seconde diode (D2) sont montées en série les unes avec les autres entre une borne de commande (330) pour appliquer une tension électrique de commande (Us) et un potentiel de référence ou entre la borne d'entrée (122) et un potentiel de référence, dans lequel un noeud de référence (REF) est raccordé au dispositif de commande (225) entre la première diode (D1) et la seconde diode (D2).

4. Circuit de protection contre les surtensions (120) selon l'une quelconque des revendications précédentes, dans lequel l'amplificateur opérationnel présente deux transistors d'amplification npn (T3, T4), un transistor d'amplification pnp (T2), deux condensateurs d'amplification (C1, C2) et trois résistances électriques d'amplification (R4, R5, R6), dans lequel l'entrée inverseuse de l'amplificateur opérationnel est réalisée comme une borne de commande d'un premier (T3) des transistors d'amplification npn (T3, T4), dans lequel l'entrée non inverseuse de l'amplificateur opérationnel est réalisée comme une borne de commande d'un second (T4) des transistors d'amplification npn (T3, T4), dans lequel une première borne du premier (T3) des transistors d'amplification npn (T3, T4) et une première borne du second (T4) des transistors d'amplification npn (T3, T4) sont raccordées par le biais d'une première (R4) des résistances d'amplification (R4, R5, R6) à un potentiel de référence, dans lequel une seconde borne du premier (T3) des transistors d'amplification npn (T3, T4) est raccordée à une seconde borne du transistor d'amplification pnp (T2) et au dispositif de régulation (227) pour fournir le signal de régulation, dans lequel une seconde borne du second (T4) des transistors d'amplification npn (T3, T4) est raccordée à la borne de sortie (124), dans lequel une première borne du transistor d'amplification pnp (T2) est raccordée à la borne d'entrée (122), dans lequel une borne de commande du transistor d'amplification pnp (T2) est raccordée par le biais d'une deuxième (R6) des résistances d'amplification (R4, R5, R6) au dispositif de régulation (227), dans lequel une première borne d'un premier (C1) des condensateurs d'amplification (C1, C2) est raccordée à la borne d'entrée (122), dans lequel une seconde borne du premier (C1) des condensateurs d'amplification (C1, C2) est montée entre la borne de commande du transistor d'amplification pnp (T2) et la deuxième (R6) des résistances d'amplification (R4, R5, R6), dans lequel une première borne d'une troisième (R5) des résistances d'amplification (R4, R5, R6) est raccordée à la borne de commande du premier (T3) des transistors d'amplification npn (T3, T4), dans lequel une seconde borne de la troisième (R5) des résistances d'amplification (R4, R5, R6) est raccordée à la borne de sortie (124), dans lequel une première borne d'un second (C2) des condensateurs d'amplification (C1, C2) est raccordée à la borne de commande du premier (T3) des transistors d'amplification (T3, T4), dans lequel une seconde borne du second (C2) des condensateurs d'amplification (C1, C2) est raccordée à un potentiel de référence.

5. Circuit de protection contre les surtensions (120) selon l'une quelconque des revendications précédentes, avec un dispositif de réglage (440) pour régler le signal de régulation en utilisant la tension d'entrée (Uᵢₙ), dans lequel le dispositif de réglage (440) présente un montage en série consistant en un commutateur et une première résistance électrique de réglage (R14) qui est montée entre le dispositif de commande (225) et un potentiel de référence, dans lequel le commutateur peut être commuté en fonction de la tension d'entrée (Uᵢₙ).

6. Circuit de protection contre les surtensions (120) selon la revendication 5, dans lequel le commutateur est réalisé comme un premier transistor de réglage npn (T6), dans lequel le dispositif de réglage (440) présente en outre un second transistor de réglage npn (T5), une deuxième résistance de réglage (R10), une troisième résistance de réglage (R11), une quatrième résistance de réglage (R12) et une cinquième résistance de réglage (R13), dans lequel une première borne du premier transistor de réglage npn (T6) est raccordée à une première borne de la première résistance de réglage (R14), dans lequel une seconde borne de la première résistance de réglage (R14) est raccordée à un potentiel de référence, dans lequel une seconde borne du premier transistor de réglage npn (T6) est raccordée au dispositif de commande (225), dans lequel une borne de commande du premier transistor de réglage npn (T6) est raccordée à une seconde borne du second transistor de réglage npn (T5), dans lequel la première borne du second transistor de réglage npn (T5) est raccordée à un potentiel de référence, dans lequel la deuxième résistance de réglage (R10) et la troisième résistance de réglage (R11) sont montées en série l'une avec l'autre entre la borne d'entrée (122) et un potentiel de référence, dans lequel une borne de commande du second transistor de réglage npn (T5) est raccordée à un noeud de réglage (445) entre la deuxième résistance de réglage (R10) et la troisième résistance de réglage (R11), dans lequel une première borne de la quatrième résistance de réglage (R12) est raccordée au noeud de réglage (445), dans lequel une seconde borne de la quatrième résistance de réglage (R12) est raccordée à la seconde borne du second transistor de réglage npn (T5), dans lequel une première borne de la cinquième résistance de réglage (R13) est raccordée à la seconde borne du second transistor de réglage npn (T5), dans lequel une seconde borne de la cinquième résistance de réglage (R13) est raccordée à la borne d'entrée (122).

7. Circuit de protection contre les surtensions (120) selon l'une quelconque des revendications précédentes, avec une résistance électrique de limitation (R7), dans lequel une première borne de la résistance de limitation (R7) est raccordée à la borne d'entrée (122), dans lequel une seconde borne de la résistance de limitation (R7) est raccordée au dispositif de régulation (227).

8. Appareil de commande (110) pour un véhicule automobile (100), dans lequel l'appareil de commande (110) présente un circuit de protection contre les surtensions (120) selon l'une quelconque des revendications précédentes et une borne d'alimentation en tension (114), dans lequel la borne de sortie (124) du circuit de protection contre les surtensions (120) est raccordée à la borne d'alimentation en tension (114) de l'appareil de commande (110).

9. Appareil de commande (110) selon la revendication 8, avec un dispositif de test (130) pour tester une fonctionnalité du circuit de protection contre les surtensions (120), dans lequel le dispositif de test (130) est conçu pour enregistrer une première valeur ou une première évolution des valeurs de la tension électrique de sortie (Uₒᵤₜ) tandis que la tension électrique de test (TST) présentant un premier niveau de tension s'applique au niveau de la borne de test (126), pour enregistrer une seconde valeur ou une seconde évolution des valeurs de la tension électrique de sortie (Uₒᵤₜ) tandis que la tension électrique de test (TST) présentant un second niveau de tension s'applique au niveau de la borne de test (126), et est conçu pour fournir un signal de test (132) en utilisant la première valeur ou la première évolution des valeurs, ainsi que la seconde valeur ou la seconde évolution des valeurs.

10. Procédé (500) pour tester un circuit de protection contre les surtensions (120) pour un appareil de commande (110) pour un véhicule automobile (100), dans lequel le circuit de protection contre les surtensions (120) est un circuit de protection contre les surtensions (120) selon l'une quelconque des revendications 1 à 7, dans lequel le procédé (500) présente les étapes suivantes :
appliquer (510) une tension électrique de test (TST) avec un premier niveau de tension à la borne de test (126) du circuit de protection contre les surtensions (120) ;
détecter (520) une première tension électrique de sortie (Uₒᵤₜ) en réponse à la tension électrique de test (TST) avec le premier niveau de tension ;
appliquer (530) une première tension électrique de test (TST) avec un second niveau de tension à la borne de test (126) du circuit de protection contre les surtensions (120), dans lequel le second niveau de tension est inférieur au premier niveau de tension ;
détecter (540) une seconde tension électrique de sortie (Uₒᵤₜ) en réponse à la tension électrique de test (TST) avec le second niveau de tension ;
vérifier (550) si la première tension de sortie (Uₒᵤₜ) détectée et la seconde tension de sortie (Uₒᵤₜ) détectée remplissent au moins un critère de test pour générer un résultat de test.
